Europäisches Patentamt

(19) European Patent Office

Office européen des brevets

(11) Publication number: 0 212 924
A2

(12) EUROPEAN PATENT APPLICATION

(21) Application number: 86306133.9

(22) Date of filing: 08.08.86

(51) Int. Cl.⁴: H 01 J 37/32, G 03 F 7/26

(30) Priority: 23.08.85 JP 184146/85

(43) Date of publication of application: 04.03.87 Bulletin 87/10

(84) Designated Contracting States: DE FR GB IT

(71) Applicant: HITACHI, LTD., 6, Kanda Surugadai 4-chome Chiyoda-ku, Tokyo 100 (JP)

(72) Inventor: Osakaya, Takayoshi, 307, 3-17, Wakaba-cho 1-chome, Tachikawa-shi Tokyo (JP)

(74) Representative: Calderbank, Thomas Roger et al, MEWBURN ELLIS & CO. 2/3 Cursitor Street, London EC4A 1BQ (GB)

(54) Plasma processing apparatus.

(57) A plasma processing apparatus generates the processing reaction by turning into plasma a process fluid that is supplied to a material (3) to be processed located in a reaction vessel (1). A source of light (9) irradiates both the process fluid turned into plasma and the material (3) with a pencil of rays such as ultraviolet rays or laser beams that produce a photo-induced reaction. The process fluid is turned into plasma by the energy of microwaves and is activated being irradiated with the pencil of rays, thereby to obtain an increased rate of reaction. Moreover, since the surface of the material (3) to be processed is irradiated with the pencil of rays, the material to be processed is prevented from being damaged by the plasma. Therefore, the material can be quickly processed without being damaged.

1

## PLASMA PROCESSING APPARATUS

The present invention relates to plasma processing. Plasma processing is used, for example, in plasma etching for removing a photoresist deposited on a sample such as of semiconductor material, a wafer by oxidation, or for chemical vapour deposition (CVD) for forming a CVD film on a wafer.

In the manufacture of semiconductor devices, it is known to use a photoresist-removing apparatus which, after a semiconductor wafer has been selectively etched, oxidizes photoresist composed of organic matter that is masking the wafer in a predetermined pattern, and gasifies and removes the photoresist.

In such an apparatus, the wafer is located between flat plate electrodes that are opposed to each other horizontally in a processing chamber. The interior of the processing chamber is evacuated to a predetermined degree of vacuum and high-frequency electric power is applied across the electrodes, and oxygen gas is supplied to the processing chamber. This causes the oxygen gas to be turned into a plasma in order to promote the reaction for oxidizing and removing the photoresist deposited on the wafer surfaces.

With an apparatus of such a structure, however, the wafer is electrically charged by the plasma, and hence the wafer to be processed is often damaged.

In another known photoresist-removing apparatus, on the other hand, oxygen gas is irradiated with ultraviolet rays to promote the reaction for oxidizing the photoresist deposited on the wafer with the oxygen gas thereby to remove the photoresists. However, the inventor of the present invention has found the fact that, with this apparatus, the rate of removing the photoresist is so small that a relatively long period of time is required to perform the processing.

Wafer processing technology in the manufacture of semiconductor devices has been disclosed, for example, in a literature "Electronic Materials", published by Kabushiki Kaisha Kogyochosakai, November 10, 1981, Separate Edition, pp. 95-102.

The present invention seeks to overcome these problems by providing an apparatus in which the plasma of process fluid is irradiated with electromagnetic radiation to produce a photo-induced reaction. This increases the processing rate without introducing other defects.

The electromagnetic radiation (hereinafter "light") may be ultraviolet rays or laser light, and microwaves may be used to turn the processing fluid into a plasma.

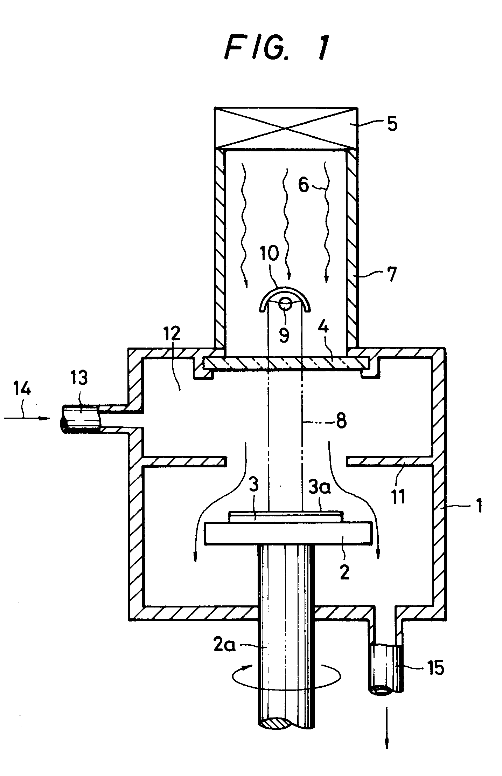

An embodiment of the invention will now be described in detail, by way of example, with reference to the accompanying drawing, in which the sole figure, Fig. 1, is a section view illustrating part of the photoresist-removing apparatus according to an embodiment of the present invention.

In Fig. 1 a susceptor 2 is provided which is horizontal relative to the bottom of a reaction vessel 1, and a wafer 3, which is sample material to be processed, is removably placed on the susceptor 2. There is a photoresist 3a on the surface of the wafer 3 for subsequent removal. The susceptor 2 is coupled, via a shaft 2a, to a motor (not shown) forming a rotary drive source, and is caused to rotate.

There is a window 4 in the upper part of the reaction vessel 1, the window 4 being composed of, for example, a synthetic quartz and being transparent to ultraviolet rays over a relatively wide range of wavelengths. A waveguide 7 is connected to the window 4, the waveguide 7 guiding microwaves of a predetermined frequency ($2.45 \times 10^9$ Hz) emitted from a magnetron 5 into the interior of the reaction vessel 1.

The waveguide 7 is equipped with an electrodeless discharge tube 9 which causes electric discharge due to the energy of microwaves 6 emitted from the magnetron 5, and which generates ultraviolet rays with a high illumination intensity. The ultraviolet rays 8 so generated pass directly or via a reflecting plate 10 on the upper part of the electrodeless discharge tube 9, to the reaction vessel 1 through the window 4. The electrodeless discharge tube 9 contains mercury gas and argon gas in a glass tube, and emits ultraviolet rays when it is irradiated with microwaves of 2.45 GHz.

A partitioning plate 11 extends horizontally in the reaction vessel 1 to divide the interior of the reaction vessel 1 into an upper and a lower part, the partitioning plate 11 having a central opening. A plasma generating chamber 12 is formed over the susceptor 2 that is located in the reaction vessel 1.

A reaction gas supply pipe 13 is connected to the upper side surface of the reaction vessel 1 and opens into the plasma generating chamber 12. Oxygen gas (process fluid) is allowed to flow at a predetermined flow rate into the plasma generating chamber 12 through the reaction gas supply pipe 13.

An exhaust pipe 15 connected to a vacuum pump (not shown) is connected to the bottom of the reaction vessel 1, so that the interior of the reaction vessel 1 can be evacuated.

The operation of this embodiment of the present invention will now be described. First, the wafer 3, on which is deposited a photoresist, is placed on the susceptor 2 in the reaction vessel 1.

Next, the interior of the reaction vessel 1 is evacuated through the exhaust pipe 15 until a predetermined degree of vacuum is reached. Oxygen gas 14 is allowed to flow at a predetermined flow rate into the plasma generating chamber 12 through the reaction gas supply pipe 13.

Then the magnetron 5 is energized. Microwaves 6 emitted from the magnetron 5 are guided into the reaction vessel 1 via the waveguide 7. Oxygen gas 14 admitted into the plasma generating chamber 12 is then turned into a plasma by the energy of the microwaves 6, and ultraviolet rays 8 emitted from the electrodeless discharge tube 9 in the waveguide 7 are incident on the surface of the wafer 3 through the plasma generating chamber 12 in the reaction vessel 1. This causes further activation of the oxygen gas 14 turned into the plasma. Therefore, when compared with the situation when the photoresist is removed by a plasma of oxygen gas 14 only, the photoresist desposited on the surface of the wafer 3 is oxidized and gasified quickly, and is removed within a relatively short period of time.

Moreover, since the surface of the wafer 3 has been irradiated with ultraviolet rays 8 emitted from the electrodeless discharge tube 9, no electric charge accumulates in the surface of the wafer 3 despite the formation of a plasma of oxygen gas 14. Therefore, if the wafer 3 is a MOS IC, its gate insulating film is not broken down since no electric charge accumulates in the surface of the wafer 3.

Using known methods it was common for a thin insulating film, such as gate oxide film or gate insulating film, often to be electrostatically broken down by the charged particles accumulated in the plasma.

Moreover, so-called irradiation damage often took place as the wafer (or other specimen) was irradiated with a beam of a particular wavelength contained in the light emitted from the plasma produced by a plasma-generating energy source such as high-frequency electric discharge.

Furthermore, with known methods bonds in the surface being etched were destroyed as the wafer (or other specimen) was bombarded by ions accelerated by an ion sheath generated near the electrode.

Moreover, the specimen was often contaminated by gas seed used for the reaction, by different elements produced by the sputtering of the electrode material, by the residue, and by the product of deposition reaction that took place in competition with the etching reaction.

According to the present invention, however, these defects inherent in the conventional art may be eliminated by using the pencil of rays such as ultraviolet rays that produce a photo-induced reaction during plasma processing.

The oxygen gas 14 is turned into plasma by the microwaves 6, and the ultraviolet rays 8 fall on the oxygen gas 14 turned into plasma and on the surface of the wafer 3, so that the photoresist deposited on the wafer 3 is removed. Therefore, as compared with removal of the photoresist by a plasma of oxygen gas 14 alone, the oxygen gas 14 turned into plasma is further activated and the photoresist is oxidized and removed quickly. Moreover, as the surface of the wafer 3 irradiated with ultraviolet rays 8, there is not an accumulation of electric charge despite the formation of plasma. Therefore, the wafer 3 is not damaged by the accumulation of electric charge.

The ultraviolet rays 8 are generated by the electrodeless discharge tube 9 that is provided in the waveguide 7 and that is operated by the energy of microwaves 6 emitted from the magnetron 5. Therefore, no wiring is needed to supply the electric power from the external unit to generate the ultraviolet rays 8, and the structure of the apparatus can be relatively simple.

After a predetermined period of time has elapsed, supply of the oxygen gas 14 is stopped, operation of the magnetron 5 is stopped, the pressure in the reaction vessel 1 returns to atmospheric pressure, the photoresist deposited on the surface of the wafer is removed without damaging the wafer, and then the wafer 3 is taken out of the reaction vessel 1.

By repeating the above-mentioned series of operations, the process is quickly carried out to remove the photoresist from a number of wafers 3 without damaging the wafers 3.

Other suitable examples of the present invention include a plasma etching apparatus and a plasma CVD apparatus.

The effects achievable by the present invention are summarized below. The processing apparatus permits promotion of the processing of a sample by turning into plasma the process fluid that is supplied to a material to

8

be processed that is placed in the reaction vessel, the apparatus being equipped with a source of light to project ultraviolet rays onto the process fluid and onto the material to be processed. As compared with the case where the process is carried out by the plasma of process fluid alone, the plasma of the process fluid is further activated by the irradiation of ultraviolet rays to give a high processing rate. With the surface of the material to be processed being irradiated with ultraviolet rays, there may also be the further advantage that electric charge does not accumulate in the surface of the material to be processed despite the presence of the plasma. Therefore, the surface of the material being processed is not damaged by the electric charge, and the material is quickly processed without being damaged.

The process fluid is turned into plasma by the energy of microwaves, and the source of light is comprised of an electrodeless discharge tube which emits ultraviolet rays upon receipt of microwave energy. Therefore, no wiring is required to supply the electric power from the external unit to emit ultraviolet rays, and the structure of the apparatus can be simplied.

Because of the above-mentioned reasons, an increased productivity is achieved by the wafer processing steps. An embodiment of the invention has been described above, but the present invention is not limited thereto only but can be modified in a variety of other ways. For example, the energy source for turning the process fluid into a plasma may employ radio-frequency (RF) electric power of 13.56 MHz, i.e., $1.356 \times 10^{7}$ Hz, instead of the microwaves. Also the source of light may be a low-pressure mercury lamp instead of an electrodeless discharging tube.

Further embodiments of the present invention may include a plasma etching apparatus and a plasma CVD apparatus. A plasma etching apparatus and a plasma CVD apparatus which are embodiments of the present invention will now be described in detail.

Another embodiment of the present invention involves a plasma processing apparatus equipped with a dry etching device having parallel flat plates, i.e., a dry etching device in which a high-frequency electric power is applied across electrodes formed by the parallel flat plate to cause etching due to plasma reaction that takes place when a reaction gas is introduced into the etching chamber and upon the ions that are accelerated through the electric field. In this embodiment the specimen is irradiated with a pencil of rays that triggers a photo-induced reaction.

A further embodiment of the present invention involves a plasma processing apparatus equipped with a dry etching device using microwaves. In such a device, the etching chamber is usually separated from the discharge chamber which uses a reaction gas such as $O_2$, $CF_4$, $CCl_4$ or the like, or the etching and discharge chambers may be combined together as a unitary structure. In an apparatus where these chambers are separated, plasma discharge takes place in a $CF_4 + O_2$ gas of about 0.1 Torr introduced into a quartz tube, due to the microwave electric power of 2.45 GHz generated by the oscillation of the magnetron. Radicals generated by the plasma discharge are guided into another etching chamber, so that polycrystalline silicon or the like is subjected to the etching relying upon the chemical reaction with radicals. Since the etching is not effected in the electric field, little damage is done to a silicon wafer. However, isotropic side etching develops, and hence there is difficulty in forming a pattern for fine processing.

In an apparatus where the chambers are of unitary structure, when a magnetic field is applied to the discharge unit, plasma is obtained of a high density. This makes it possible to effect etching under a low pressure ($10^{-4}$ Torr) while reducing the width of side etching.

The present invention can be adapted to a piece processing system which processes wafers with plasma piece by piece, or to a batch processing system which processes a number of wafers with plasma at one time.

The present invention makes use of a pencil of rays that produces photo-induced reaction during the processing with plasma, and enhances the rate of processing with plasma while reducing damage to the specimens.

The pencil of rays that produces the photo-induced reaction, may be a laser beam rather than ultraviolet rays.

11

The source of ultraviolet rays, may be any of a variety of ultraviolet ray sources in addition to the electrodeless discharge tube. In a plasma processing apparatus, the source of the pencil of rays that produces the photo-induced reaction, such as the ultraviolet ray source, can be in the plasma reaction chamber or in the waveguide for microwaves, or can be installed outside thereof. Described below are the laser beams for producing a photo-induced reaction. A variety of plasma CVD films can be formed by the CVD method as tubulated below.

| Products | Gases | Sources of light |
|---|---|---|
| Si | $Si_2H_4$ | ArF laser, mercury lamp |
| | $SiH_4$ | ArF laser, KrF laser |
| $SiO_2$ | $SiH_4 + N_2O$ | ArF laser, mercury lamp |
| | $SiH_4 + O_2$ | |
| Si-N | $SiH_4 + NH_3$ | Mercury lamp |
| | $SiH_4 + N_2H_4$ | |
| $Al_2O_3$ | $Al(CH_3)_3 + N_2O$ | ArF laser, KrF laser |
| Cr | $Cr(CO)_6$ | Excimer laser, copper ion laser |
| Fe | $Fe(CO)_5$ | Excimer laser, copper ion laser |
| Mo | $Mo(CO)_6$ | Excimer laser, copper ion laser |
| W | $W(CO)_6$ | Excimer laser, copper ion laser |
| | $WF_4$ | |
| Al | $Al(CH_3)_3$ | $Ar^+$ laser |

A variety of materials can be etched with plasma using energies of light tabulated below.

| Materials to be etched | Reaction gases | Sources of light |
|---|---|---|
| Si | $SF_6$ | ArF excimer laser |
| Si | $NF_3 + H_2$ | ArF excimer laser |
| $SiO_2$ | $NF_3 + H_2$ | ArF excimer laser |
| Polycrystalline Si | $Cl_2 + Si(CH_3)_4$ | Low-pressure mercury lamp and XeCl excimer laser |
| Al | $Cl_2$ | XeCl excimer laser |
| GaAs | HCl | ArF excimer laser |
| GaAs | $CCl_4$ | $Ar^+$ laser |

The reaction can be controlled by selecting a predetermined wavelength for producing the photo-induced reaction.

The light exhibits unique characteristics even as a source of heat. In particular, when a laser beam is used, the energy density can be greatly increased. Moreover, the energy distribution exhibits a very high resolving power from the standpoint of space or time.

In the photo-induced CVD, a variety of light can be combined so that the wavelengths of the light used lie within the light-absorbing region of the reaction gas.

The photo-induced CVD film can be formed at a low temperature giving little damage to the underlying layers or the deposited film.

The photo-induced processing method induces the chemical reaction by light energy. Therefore, the reaction proceeds purely radically essentially in the absence of electric fields. Compared with the use of a plasma CVD method or a sputtering method, therefore, the CVD film can be formed at a low temperature without causing damage to the underlying layers or the deposited films.

The photo-induced CVD of the present invention makes it possible independently to control the vapour phase step, the surface step, and the substrate temperature, which are three primary elements in the process for forming the CVD film.

When using a photo-induced CVD method, the surface of the specimen is not heated significantly. Therefore, no damage is caused to the underlying photoresist film intermediate insulating film or pn junction of a semiconductor element. Even after the film has been deposited, the wafer may be subjected to a variety of processings such as lithography and the like.

In addition to using a laser beam of a single wavelength, the photo-induced reaction can be carried out relying upon a thermal process and a lamp in combination with a plurality of laser beams. In this case, the CVD film is formed under more ideal conditions since the photo-induced CVD is effected under the condition where the substrate, the reaction gas and the atmosphere in the action chamber are heated by the high-frequency waves and by the infrared-ray lamp.

15

CLAIMS:

1. A plasma processing apparatus having a reaction vessel (1) with a chamber for containing a material (3) to be processed, and means for turning a process fluid supplied to the chamber (1) into a plasma;

characterised in that:

the apparatus has a source of electromagnetic radiation (9) for generating rays for application to the material (3) and the process fluid, to cause a photo-induced reaction in the plasma of process fluid.

2. An apparatus according to claim 1, wherein the process fluid is turned into a plasma by the energy of microwaves (6), and the source of light is an electrodeless discharge tube (9) adapted to emit ultra-violet rays on energization by the microwaves.

3. An apparatus according to claim 1, or claim 2 wherein the process fluid and the material (3) to be processed are oxygen gas and a wafer, respectively, and said processing apparatus is a photoresist-removing apparatus.

4. An apparatus according to claim 1, or claim 2, wherein the process fluid and the material (3) to be processed are a reaction gas such as $O_2$, $CF_4$ or $CCl_4$, and a wafer, respectively, and the processing apparatus is a plasma etching apparatus.

5. An apparatus according to claim 1 or claim 2, wherein the process fluid and the material (3) to be processed are a CVD reaction gas and a wafer, respectively, and the

16

processing apparatus is a plasma CVD apparatus.

## FIG. 1